**Europäisches Patentamt**

(19) **European Patent Office**

**Office européen des brevets**

(11) Publication number : **0 414 362 B1**

(12) **EUROPEAN PATENT SPECIFICATION**

(45) Date of publication of patent specification : **14.04.93 Bulletin 93/15**

(51) Int. Cl.⁵ : **H05K 3/10**

(21) Application number : **90307547.1**

(22) Date of filing : **10.07.90**

(54) **Method for forming conductive traces on a substrate.**

(30) Priority : **22.08.89 US 397070**

(43) Date of publication of application : **27.02.91 Bulletin 91/09**

(45) Publication of the grant of the patent : **14.04.93 Bulletin 93/15**

(84) Designated Contracting States : **DE FR GB IT**

(56) References cited :
**EP-A- 0 003 364**
**FR-A- 1 420 044**
**US-A- 4 668 533**
**TECHNISCHE RUNDSCHAU, vol. 79, no. 22, 29 May 1987, pages 20, 21, Bern, CH; H. BENNINGHOFF: "Leiterplattenfertigung mit weniger und ohne Chemie"**

(73) Proprietor : **Hewlett-Packard Company Mail Stop 20 B-O, 3000 Hanover Street Palo Alto, California 94304 (US)**

(72) Inventor : **Cloutier, Frank L. 37 Stevens Road, 04-01 Singapore 1025 (SG)**
Inventor : **Min, Siow Wee Blk 407, Bedok North Avenue 3, No. 05-185 Singapore 1646 (SG)**
Inventor : **Chieng, Ching King Block 117, 07-3755 Bukit Merah Central Singapore 0315 (SG)**

(74) Representative : **Colgan, Stephen James et al CARPMAELS & RANSFORD 43 Bloomsbury Square London WC1A 2RA (GB)**

## Description

The present invention generally relates to the formation of electrical traces on a substrate, and more particularly to the formation of electrical traces using an ink jet system to apply a circuit pattern, followed by the application of a thin film metal layer to the pattern.

The development of increasingly sophisticated computer and electronic systems has created a corresponding need for circuit production methods of improved efficiency and economy. In order to achieve these goals, many circuit fabrication methods have been developed and used. For example, U.S. Patent No. 4,668,533 to Miller involves a printed circuit production method which uses an ink containing a conductive metal or metal-containing activator. As a further example, EP-A-0003364 discloses a printed circuit production method using an adhesive ink on which a metallic powder is applied. In a preferred embodiment, the ink is delivered using an ink jet system, followed by the application of a secondary metal layer using an electroless metal plating solution. Other methods of circuit fabrication involve the use of screen printing techniques which are well known in the art.

However, a need remains for an improved method of manufacturing conductive circuit traces in a rapid and efficient manner with a minimal number of process steps. The present invention satisfies this need, as described herein below.

### Summary of the Invention

It is an object of the present invention to provide a circuit fabrication method which is capable of producing conductive traces on a substrate in an efficient and rapid manner.

It is another object of the invention to provide a circuit fabrication method which uses a minimal number of process steps.

It is a still further object of the invention to provide a circuit fabrication method which uses readily available, economical materials.

It is an even further object of the invention to provide a circuit fabrication method which uses ink jet technology to deliver an ink pattern to a substrate, followed by the application of a metal layer thereto.

In accordance with the foregoing objects, the method of claim 1 is provided.

These and other objects, features, and advantages of the invention will become apparent from the following Detailed Description of a Preferred Embodiment and Drawings.

### Brief Description of the Drawings

Fig. 1 is a schematic representation of the process steps, materials, and components used to produce conductive traces on a substrate in accordance with the invention.

Fig. 2 is a cross sectional view of a flexible film sheet having a metal layer thereon used in connection with the invention.

Fig. 3 is an enlarged schematic representation showing the formation of a conductive trace pattern on a substrate using an adhesive-based ink composition.

### Detailed Description of a Preferred Embodiment

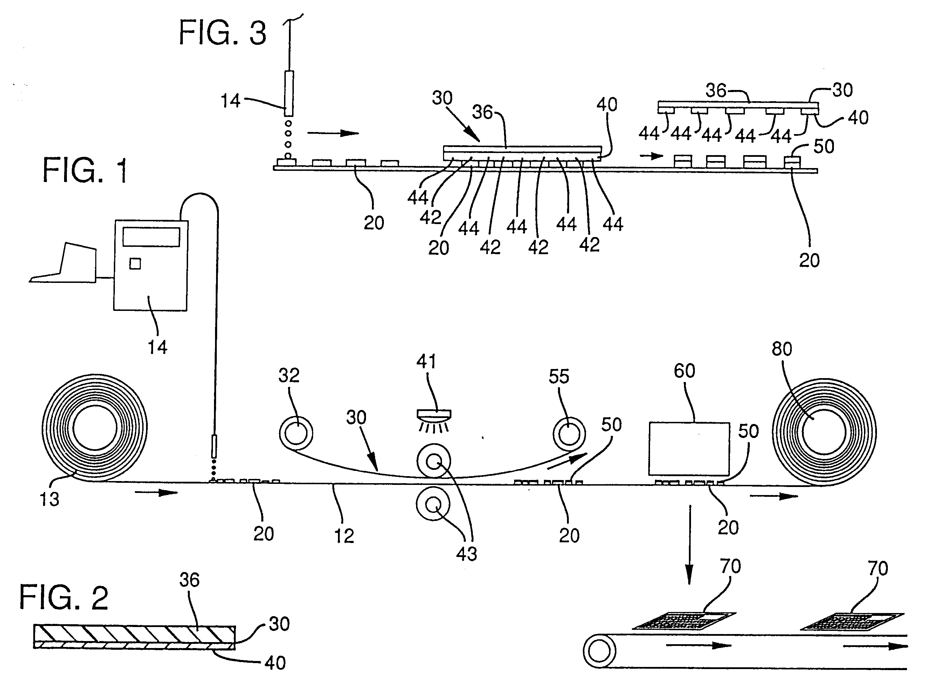

The present invention involves an improved method for producing conductive circuit traces in a highly efficient and economical manner. In accordance with the invention, an ink composition is first used to form a selected circuit pattern on a substrate. With reference to Fig. 1, a substrate 12 is illustrated. A wide variety of substrates known in the art may be used, including thin-film polyester, ABS (acrylonitrile-butadiene-styrene) plastic, PC (polycarbonate) plastic, PVC (polyvinyl chloride) plastic, and PC/ABS (50:50) blends. Other substrates may be used, and the invention shall not be limited to those listed above.

To implement the present invention on a mass-production scale, it is desirable to dispense the substrate 12 from a roll 13 (Fig. 1.) although the substrate 12 may consist of a single flat sheet if desired. As the substrate 12 is delivered from the roll 13, it moves toward and through a computer controllable ink jet printing apparatus 14 known in the art. In a preferred embodiment, a thermal ink jet printing system is used. Typical thermal ink jet systems include an ink reservoir in fluid communication with an orifice plate and resistor assembly. These types of systems are known in the art, and described in the <u>Hewlett-Packard Journal</u>, May 1985, Vol. 36, No. 5. In addition, exemplary ink jet systems with which the invention may be used are illustrated in U.S. Patents 4,500,895; 4,794,409; 4,791,438; 4,677,447; and 4,490,728. However, the invention shall not be limited to any particular type of ink jet system, and may be implemented using a wide variety of systems known in the art, including those listed above.

The ink jet printing apparatus 14 is designed to dispense ink in a selected circuit pattern 20 on the substrate 12 (Figs. 1 and 3.) The geometry of the circuit pattern 20 may be varied as desired, depending on the ultimate use for which the circuit is intended. In a preferred embodiment, the pattern 20 will have a thickness of about 0.5 - 2.0 mil (1.0 mil = 25.4 μm), with 1.0 mil being preferred.

The printing apparatus 14 is supplied with a specially formulated ink composition designed to adhere to the substrate 12 in a rapid and secure manner. The composition includes about 5 - 40% by weight adhesive (30% by weight = preferred), and about 60 - 95% by weight solvent (70% by weight = preferred.) A preferred adhesive usable in the invention is a product manufactured by the "Loctite Corporation of Cleveland, Ohio under the name "Loctite 408." This material consists of a cyanoacrylate-based compound. Another adhesive which may be used is manufactured by Emhart Australia Pty. Ltd. of Victoria, Australia under the name "Bostik Super Bond." However, the present invention shall not be limited to the specific adhesives described above, and other adhesives known in the art may be used accordingly. These adhesives should be non-toxic, non-flammable, have a viscosity of about 5 - 100 cps (1cps = $10^{-3}$Pa.s), and a surface tension of about 20 - 60 dynes/cm.

As previously indicated, the adhesive is combined with one or more solvents. Exemplary solvents include ethylene glycol phenyl ether, gamma-butyrolactone, methyl ethyl ketone, water, and mixtures thereof. But other solvents known in the art may be used. In addition, the solvents may be mixed in a variety of experimentally determined combinations, depending on the substrate/adhesive involved, as well as type of ink jet delivery system being used.

A variety of specific ink compositions are described below in the following Examples:

## EXAMPLE 1

| COMPONENT | WT % |
|---|---|
| Loctite 408 (adhesive) | 30 |
| gamma butyrolactone (solvent) | 50 |
| methyl ethyl ketone (solvent) | 10 |
| ethylene glycol phenyl ether (solvent) | 5 |
| water (solvent) | 5 |
| | 100% |

## EXAMPLE 2

| COMPONENT | WT % |
|---|---|
| Bostik Super Bond (adhesive) | 30 |
| gamma butyrolactone (solvent) | 50 |
| methyl ethyl ketone (solvent) | 10 |
| ethylene glycol phenyl ether (solvent) | 5 |
| water (solvent) | 5 |
| | 100% |

## EXAMPLE 3

| COMPONENT | WT % |
|---|---|
| Loctite 408 (adhesive) | 40 |
| gamma butyrolactone (solvent) | 50 |
| methyl ethyl ketone (solvent) | 5 |
| water (solvent) | 5 |
| | 100% |

In a preferred embodiment, the ink composition will have a viscosity of about 5 - 25 cps (10 cps = optimum), and a surface tension of about 30 - 60 dynes/cm (50 dynes/cm = optimum.)

Following application of the ink pattern 20 to the substrate 12, a thin, flexible sheet of metallized film 30 is applied to the pattern 20. The film 30 is preferably provided in a roll 32, and is more specifically illustrated in Fig. 2. With continued reference to Fig. 2, the film 30 includes a backing layer 36 about 5.0 mil thick (1 mil = 25.4 micrometers) preferably manufactured of a plastic material known in the art including but not limited to cellophane or polyester. Detachably secured to the backing layer 36 by an adhesive (not shown) is a metal layer 40 which is about 2.0 mil thick. The metal layer 40 may be manufactured from a wide variety of metals and alloys including but not limited to gold, copper, silver, aluminum and mixtures thereof. The film 30 and technical details relative thereto are specifically described in U. S. Patent 3,519,512. Also, the film 30 is commercially available from Omnicrom Systems Limited, U.K.

In use, the film 30 is urged downward against the pattern 20, with various portions 42 of the metal layer 40 contacting the pattern 20, as illustrated in Fig. 3. In a preferred embodiment, this step is accomplished simultaneously with the application of heat and pressure to the film 30 and pattern 20. An infra-red lamp, oven, or other conventional heating apparatus 41 is used to heat the film 30 to a temperature of about 20 - 250 degrees C, with a sub-range of about 50 - 70 degrees C being preferred. In addition, the film 30 is applied to the pattern 20 using a downward pressure of about 3 - 5 atmospheres (1 atm = 10 newton/sq. cm.) This pressure is generated using a pinch roller assembly 43 known in the art or other comparable pressure-generating device. The temperature and pressure levels described above enable the adhesive in the ink to securely engage and affix the portions 42 of the metal layer 40 to the substrate 12. The unaffixed portions 44 of the metal layer 40 surrounding the portions 42 shown in Fig. 3 remain detached from the substrate 12.

After the passage of about 3 - 20 seconds, the film 30 is withdrawn from the substrate 12. The portions 42 of the metal layer 40 contacting the pattern 20 tear away from the metal layer 40 and remain adhered to the substrate 12, thus forming a metal trace pattern 50 on the substrate 12. The pattern 50 has a configuration identical with that of the initial pattern 20. The unaffixed portions 44 of the metal layer 40 remain attached to the backing layer 36 of the film 30. In a preferred embodiment, the remaining film 30 is wound onto a residue roll 55. The substrate 12 with the completed trace pattern 50 thereon is then cut as desired using a cutter 60 known in the art to produce individual circuit units 70 suitable for use in a wide variety of applications. In addition, any residual substrate 12 is preferably fed onto a collection roll 80, as illustrated in Fig. 1.

The present invention represents a highly efficient method for applying metal trace patterns to a substrate. It is especially suitable for use in high-speed, mass production manufacturing facilities. In addition, the use of an ink jet system to apply an initial pattern to the substrate enables the pattern to be applied in a highly precise and controlled manner.

Accordingly, it is anticipated that suitable modifications may be made to the invention by individuals skilled in the art which are entirely within the scope of the invention. For example, the chemicals used to prepare the ink composition, as well as the materials used to prepare the metallized film may be selectively varied.

## Claims

1. A method for applying conductive traces (50) to a substrate (12) comprising:
   providing a substrate (12);
   applying ink from an ink jet system to said substrate (12) in a pattern (20), said ink comprising an adhesive therein:

placing a sheet of metallized film (30) comprising a backing layer (36) and a metal layer (40) detachably secured thereto against said substrate (12) so as to allow at least one portion (42) of said metal layer (40) to contact said ink and adhere thereto; and

removing said film (30) from said substrate (12), said portion (42) of said metal layer (40) in contact with said ink remaining adhered thereto with any non-adhered portions (44) of said metal layer (40) being removed with said film (30), said portion (42) of said metal layer (40) remaining adhered to said ink forming an arrangement of conductive traces (50) identical with said pattern (20) formed from said ink.

2. The method of claim 1 wherein said applying of said ink to said substrate (12) comprises the steps of:
supplying said ink to a thermal ink jet printing apparatus (14); and
activating said apparatus (14) in order to deliver said ink to said substrate (12).

3. The method of claim 1 or claim 2 wherein said substrate (12) comprises a material selected from the group consisting of polyester, acrylonitrile-butadiene-styrene plastic, polyvinyl chloride plastic, polycarbonate plastic, and mixtures thereof.

4. The method of any one of claims 1-3 wherein said ink comprises about 5 - 40% by weight adhesive.

5. The method of any preceding claim wherein said layer of metal (40) comprises a metal selected from the group consisting of silver, gold, copper, aluminium and mixtures thereof.

6. The method of any preceding claim wherein said placing of said film (30) against said substrate (12) further comprises the step of heating said film (30) at a temperature of about 20 - 250 degrees C.

7. The method of claim 6 wherein said film (30) is urged against said substrate (12) at a pressure of about 30-50 N/cm$^2$ (3 to 5 atm).

8. The method of any preceding claim wherein about 3 to 20 seconds are allowed to pass between said placing of said film (30) against said substrate (12) and said removing of said film (30) from said substrate (12).

**Patentansprüche**

1. Verfahren zum Aufbringen leitender Spuren (50) auf ein Substrat (12), umfassend:
Bereitstellen eines Substrates (12);
Aufbringen von Tinte aus einem Tintenstrahlsystem auf das Substrat (12) in einem Muster (20), wobei die Tinte einen Klebstoff enthält;
Plazieren einer Schicht aus einer metallisierten Folie (30) mit einer Stützlage (36) und einer daran entfernbar gesicherten Metallage (40), auf dem Substrat (12), um mindestens einen Abschnitt (42) der Metallage (40) die Tinte zu kontaktieren und daran ankleben zu lassen; und
Entfernen der Folie (30) von dem Substrat (12), wobei derjenige Abschnitt (42) der Metallage (42), der in Kontakt mit der Tinte ist, daran angeklebt bleibt, während sämtliche nicht anhaftenden Abschnitte (44) der Metallage (40) zusammen mit der Folie entfernt werden, und derjenige Abschnitt (42) der Metallage (40), der an der Tinte anklebt, eine Anordung aus leitenden Spuren (50) bildet, die identisch mit dem von der Tinte geformten Muster (20) sind.

2. Verfahren nach Anspruch 1, bei dem das Aufbringen von Tinte auf das Substrat (12) folgende Schritte umfaßt:
Speisen der Tinte zu einem thermischen Tintenstrahldrucker (14) und
Aktivieren des Druckers (14) zum Abgeben der Tinte auf das Substrat (12).

3. Verfahren nach Anspruch 1 oder 2, bei dem das Substrat (12) einen Werkstoff der Gruppe Polyester, Acrylnitril-Butadien -Styrol-Kunststoff, Polyvinyl-Chlorid-Kunststoff, Polykarbonat-Kunststoff und Gemische davon umfaßt.

4. Verfahren nach einem der Anspüche 1 bis 3, bei dem die Tinte etwa 5 - 40 Gewichtsprozent Klebstoff enthält.

**5.** Verfahren nach einem der vorangehenden Anspüche, bei dem die Metallage (40) ein Metall aus der Gruppe Silber, Gold, Kupfer, Aluminium und Gemische davon umfaßt.

**6.** Verfahren nach einem der vorangehenden Ansprüche, bei dem das Plazieren der Folie (30) auf dem Substrat (12) ferner den Schritt des Heizens der Folie (30) auf eine Temperatur von etwa 20 - 250°C umfaßt.

**7.** Verfahren nach Anspruch 6, bei dem die Folie (30) unter einem Druck von etwa 30 - 50 N/cm² gegen das Substrat (12) gedrückt wird.

**8.** Verfahren nach einem der vorangehenden Ansprüche, bei dem zwischen dem Plazieren der Folie (30) auf dem Substrat (12) und dem Entfernen der Folie (30) von dem Substrat (12) 3 - 20 Sekunden verstreichen gelassen werden.

## Revendications

**1.** Procédé d'application de traces conductrices (50) sur un substrat (12) comprenant :
la fourniture d'un substrat (12) ;
l'application d'une encre en provenance d'un système de jet d'encre sur ledit substrat (12) selon un motif (20), ladite encre comprenant un adhésif en son sein ;
le placement d'un feuille de film métallisé (30) comprenant une couche de support (36) et une couche de métal (40) qui lui est fixée de façon détachable contre ledit substrat (12) de manière à permettre à au moins une partie (42) de ladite couche de métal (40) d'entrer en contact avec ladite encre et de lui adhérer ; et
l'enlèvement dudit film (30) dudit substrat (12), ladite partie (42) de ladite couche de métal (40) qui est en contact avec ladite encre continuant à lui adhérer, certaines parties non en adhérence (44) de ladite couche de métal (40) étant ôtées dudit film (30), ladite partie (42) de ladite couche de métal (40) continuant à adhérer à ladite encre en formant un agencement de traces conductrices (50) identique audit motif (20) formé à partir de ladite encre.

**2.** Procédé selon la revendication 1, dans lequel ladite application de ladite encre sur ledit substrat (12) comprend les étapes de :
application de ladite encre à un appareil d'impression à jet d'encre thermique (14) ; et
activation dudit appareil (14) afin de délivrer ladite encre sur ledit substrat (12).

**3.** Procédé selon la revendication 1 ou 2, dans lequel ledit substrat (12) comprend un matériau choisi parmi le groupe qui comprend du polyester, du plastique d'acrylonitrile-butadiène-styrène, du plastique de chlorure de polyvinyle, du plastique de polycarbonate et des mélanges de ceux-ci.

**4.** Procédé selon l'une quelconque des revendications 1 à 3, dans lequel ladite encre comprend environ entre 5 à 40% d'adhésif par unité de poids.

**5.** Procédé selon l'une quelconque des revendications précédentes, dans lequel ladite couche de métal (40) comprend un métal choisi parmi le groupe qui comprend l'argent, l'or, le cuivre, l'aluminium et des mélanges de ceux-ci.

**6.** Procédé selon l'une quelconque des revendications précédentes, dans lequel ledit placement dudit film (30) contre ledit substrat (12) comprend en outre l'étape de chauffage dudit film (30) à une température comprise entre environ 20° C et environ 250° C.

**7.** Procédé selon la revendication 6, dans lequel ledit film (30) est poussé contre ledit substrat (12) selon une pression d'environ 30 à 50 N/cm² (3 à 5 atmosphères).

**8.** Procédé selon l'une quelconque des revendications précédentes, dans lequel environ 3 à 20 secondes peuvent s'écouler entre ledit placement dudit film (30) contre ledit substrat (12) et ledit enlèvement dudit film (30) dudit substrat (12).

FIG. 1

FIG. 2

FIG. 3